Europäisches Patentamt

European Patent Office

Office européen des brevets

(11)  **EP 4 220 207 B1**

(12)  ## EUROPÄISCHE PATENTSCHRIFT

(45) Veröffentlichungstag und Bekanntmachung des Hinweises auf die Patenterteilung:
**18.09.2024  Patentblatt 2024/38**

(21) Anmeldenummer: **23150575.1**

(22) Anmeldetag: **06.01.2023**

(51) Internationale Patentklassifikation (IPC):
**G01R 31/367** (2019.01)   **G01R 31/3828** (2019.01)
**G01R 31/3842** (2019.01)   *G01R 31/00* (2006.01)

(52) Gemeinsame Patentklassifikation (CPC):
**G01R 31/367; G01R 31/3828; G01R 31/3842;**
G01R 31/008

(54) **VERFAHREN UND EINRICHTUNG ZUM SCHÄTZEN DER KAPAZITÄT EINES ENERGIESPEICHERS**

METHOD AND DEVICE FOR ESTIMATING THE CAPACITY OF AN ENERGY STORE

PROCÉDÉ ET DISPOSITIF D'ESTIMATION DE LA CAPACITÉ D'UN ACCUMULATEUR D'ÉNERGIE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **26.01.2022  DE 102022200884**

(43) Veröffentlichungstag der Anmeldung:
**02.08.2023  Patentblatt 2023/31**

(73) Patentinhaber: **Siemens Mobility GmbH**
**81739 München (DE)**

(72) Erfinder: **Hassler, Stefan**
**91281 Kirchenthumbach, OT Neuzirkendorf (DE)**

(74) Vertreter: **Siemens Patent Attorneys**
**Postfach 22 16 34**
**80506 München (DE)**

(56) Entgegenhaltungen:
CN-A- 110 286 324   US-A1- 2014 058 595
US-A1- 2017 244 137   US-A1- 2021 190 876
US-A1- 2021 215 770

- XIONG RUI ET AL: "A data-driven multi-scale extended Kalman filtering based parameter and state estimation approach of lithium-ion olymer battery in electric vehicles", APPLIED ENERGY, ELSEVIER SCIENCE PUBLISHERS, GB, vol. 113, 23 August 2013 (2013-08-23), pages 463 - 476, XP028762963, ISSN: 0306-2619, DOI: 10.1016/J.APENERGY.2013.07.061

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung bezieht sich auf ein Verfahren und eine Einrichtung zum Schätzen der Kapazität eines Energiespeichers unter Bildung eines Kapazitätsschätzwerts.

Der Artikel "A data-driven multi-scale extended Kalman filtering based parameter and state estimation approach of lithium-ion polymer battery in electric vehicles" von Rui Xiong et al. offenbart ein derartiges Verfahren, wobei im Rahmen des Verfahrens der Kapazitätsschätzwert und ein Schätzfehlerwert bestimmt werden.

Die Kapazität einer Batterie ist eine elementare Größe für die Schätzung des Ladezustands. Die Kapazität ändert sich allerdings mit der Zeit. Wesentliche Änderungseinflüsse sind Alterung, die Verwendungsweise, Ladezyklen, das Temperaturprofil und vieles mehr. Aus diesem Grund ist es wichtig, über die Lebensdauer der Batterie die Kapazität bzw. deren Änderung ermitteln zu können.

Der Erfindung liegt die Aufgabe zugrunde, ein einfach durchführbares Verfahren zum Schätzen der Kapazität eines Energiespeichers anzugeben.

Diese Aufgabe wird erfindungsgemäß durch ein Verfahren mit den Merkmalen gemäß Patentanspruch 1 gelöst. Vorteilhafte Ausgestaltungen des erfindungsgemäßen Verfahrens sind in Unteransprüchen angegeben.

Danach ist erfindungsgemäß vorgesehen, dass im Rahmen des Verfahrens der Kapazitätsschätzwert und ein den Schätzfehler des Kapazitätsschätzwerts angebender Schätzfehlerwert bestimmt werden, wobei das Schätzen davon abhängig ist, ob zum jeweiligen Schätzzeitpunkt aktuelle Messwerte, die eine messwertgestützte Schätzung ermöglichen, vorliegen oder nicht, wobei bei Nichtvorliegen aktueller Messwerte die Schätzung unter Heranziehung des jeweils zuvor geschätzten Kapazitätsschätzwerts und des jeweils zuvor geschätzten Schätzfehlerwerts durchgeführt wird und ein die Varianz des Schätzfehlerwerts beschreibender Varianzwert aktualisiert wird, und bei Vorliegen aktueller Messwerte die Schätzung unter Heranziehung des jeweils zuvor geschätzten Kapazitätsschätzwerts, des jeweils zuvor geschätzten Schätzfehlerwerts, der aktuellen Messwerte und des Varianzwerts durchgeführt wird.

Ein wesentlicher Vorteil des erfindungsgemäßen Verfahrens ist darin zu sehen, dass die Schätzschritte unabhängig davon durchgeführt werden können, ob neue aktuelle Messwerte, die eine messwertgestützte Schätzung ermöglichen, vorliegen oder nicht. Durch diese Entkopplung von Messergebnissen kann der Rechenaufwand, der für die Schätzung aufgewandt werden soll bzw. kann, in einem weiten Rahmen frei gewählt werden. Beispielsweise können die Schätzvorgänge stündlich durchgeführt werden, unabhängig von dem Betrieb des Energiespeichers und unabhängig davon, ob Ruhestromphasen, die eine Leerlaufspannungsmessung ermöglichen würden, auftreten oder nicht.

Durch die erfindungsgemäß vorgesehene Aktualisierung des Varianzwerts kann dem Umstand Rechnung getragen werden, dass bei längeren Phasen ohne messwertunterstützte Schätzung die Schätzwerte weniger verlässlich sein werden; beispielsweise kann bei jedem Schätzschritt ohne aktuelle Messwerte der Varianzwert im Rahmen der Aktualisierung erhöht werden, um das Absinken der Vertrauenswürdigkeit der Schätzergebnisse zu quantifizieren.

Als vorteilhaft wird es angesehen, wenn jeweils bei Beginn einer stromlosen Phase geprüft wird, ob diese eine vorgegebene Mindestzeitspanne anhält. Ist dies der Fall, so wird vorzugsweise eine an dem Energiespeicher anliegende Spannung unter Bildung eines Leerlaufspannungswertes gemessen.

Bei jedem Schätzvorgang wird vorzugsweise jeweils geprüft, ob seit dem letzten Schätzvorgang zumindest ein neuer Leerlaufspannungswert erfasst worden ist. Bei Vorliegen zumindest eines neuen Leerlaufspannungswerts wird vorzugsweise eine Ladungsmenge, die im Zeitraum zwischen der Erfassung des zeitlich letzten neuen Leerlaufspannungswerts und der Erfassung des zeitlich vorletzten Leerlaufspannungswerts in den Energiespeicher hinein- oder aus diesem herausgeflossen ist, unter Bildung einer Ladungsmengenangabe ermittelt.

Bei der Berechnung des Kapazitätsschätzwerts und des Schätzfehlerwerts werden vorzugsweise als die genannten aktuellen Messwerte die zwei letztgenannten Leerlaufspannungswerte und die Ladungsmengenangabe berücksichtigt.

Mit den zwei letztgenannten Leerlaufspannungswerten können in vorteilhafter Weise Ladezustandsangaben und eine Ladezustandsänderungsangabe gebildet werden, die bei der Schätzung berücksichtigt werden kann.

Die Erfassung der Ladungsmenge umfasst vorzugsweise ein messtechnisches Abtasten des Stromes mit einer Abtastrate, die zumindest hundertmal größer als die Wiederholrate der Schätzung ist.

Bei Vorliegen aktueller Messwerte wird die Schätzung vorzugsweise zunächst ohne Berücksichtigung der aktuellen Messwerte durchgeführt unter Bildung eines Modellkapazitätsschätzwerts und eines Modellkapazitätsschätzfehlerwerts. Anschließend werden der Kapazitätsschätzwert und der Schätzfehlerwert vorzugsweise unter Heranziehung des Modellkapazitätsschätzwerts, des Modellkapazitätsschätzfehlerwerts, der aktuellen Messwerte und des die Varianz des Modellkapazitätsschätzfehlerwerts angebenden Varianzwerts bzw. einer diesen enthaltenden Zustandskovarianzmatrix berechnet.

Die Berechnung des Modellkapazitätsschätzwerts und des Modellkapazitätsschätzfehlerwerts ist bei Vorliegen der aktuellen Messwerte vorzugsweise identisch mit der Berechnung des Kapazitätsschätzwerts und des Schätzfehlerwerts im Falle eines Nichtvorliegens aktueller Messwerte.

Bei einer besonders bevorzugten Ausgestaltung des Verfahrens ist vorgesehen, dass der Modellkapazitätsschätzwert und der Modellkapazitätsschätzfehlerwert berechnet werden, indem der jeweils zuvor geschätzte Kapazitätsschätzwert als Modellkapazitätsschätzwert und der jeweils zuvor geschätzte Schätzfehlerwert als Modellschätzfehlerwert angesehen wird.

Vorteilhaft ist es, wenn bei jedem Schätzschritt der die Varianz des Schätzfehlerwerts angebende Varianzwert gemäß einer vorgegebenen Erhöhungsvorschrift erhöht wird und der erhöhte Varianzwert in der Zustandskovarianzmatrix anstelle des entsprechenden vorherigen Varianzwerts abgespeichert wird, bevor die Zustandskovarianzmatrix bei der Berechnung des Kapazitätsschätzwerts und des Schätzfehlerwerts berücksichtigt wird.

Die Erhöhungsvorschrift sieht vorzugsweise vor, zur Bildung des erhöhten Varianzwerts den vorherigen Varianzwert um einen vorgegebenen Erhöhungswert zu erhöhen, der proportional zu der Zeitspanne zwischen der aktuellen Schätzung und der vorherigen Schätzung ist.

Alternativ oder zusätzlich kann die vorgegebene Erhöhungsvorschrift vorsehen, die Varianz des Schätzfehlerwerts gemäß einem Wiener-Prozess zu erhöhen.

Bei Nichtvorliegen aktueller Messwerte werden der vorherige Kapazitätsschätzwert und der Schätzfehlerwert vorzugsweise unverändert gelassen, und es werden der vorherige Kapazitätsschätzwert als der aktuelle Kapazitätsschätzwert und der vorherige Schätzfehlerwert als der aktuelle Schätzfehlerwert ausgegeben. Erhöht wird jedoch vorzugsweise der die Varianz des Schätzfehlerwerts angebende Varianzwert gemäß der Erhöhungsvorschrift, und es wird der erhöhte Varianzwert in der Zustandskovarianzmatrix anstelle des dort zuvor gespeicherten Varianzwerts abgespeichert. Die jeweils aktuelle Zustandskovarianzmatrix wird vorzugsweise berücksichtigt, wenn bei nachfolgenden Schätzvorgängen aktuelle Messwerte einbezogen werden.

Die Schätzung wird vorzugsweise in regelmäßigen zeitlichen Abständen wiederholt, zum Beispiel stündlich, unabhängig vom Vorliegen oder Nichtvorliegen aktueller Messwerte.

Bei Vorliegen aktueller Messwerte werden der Kapazitätsschätzwert und der Schätzfehlerwert vorzugsweise berechnet auf der Basis

- des zuvor geschätzten Kapazitätsschätzwerts,
- des zuvor geschätzten Schätzfehlerwerts,
- der aktuellen Messwerte,
- einer Messgenauigkeitsangabe, die die Messgenauigkeit der aktuellen Messwerte oder eines mit diesen berechneten Zwischenwerts angeben, und
- des aktuellen Varianzwerts, der die Varianz des Schätzfehlerwerts angibt.

Die Schätzung wird vorzugsweise mit einem Kalmanfilter durchgeführt.

Der Schätzfehlerwert gibt vorzugsweise die Varianz des Kapazitätsschätzwerts an.

Die Berechnung des Modellkapazitätsschätzwerts $C_k^-$ und des Modellschätzfehlerwerts $\delta C_k^-$ erfolgt vorzugsweise gemäß:

$$\begin{bmatrix} C \\ \delta C \end{bmatrix}_k^- = \begin{bmatrix} C \\ \delta C \end{bmatrix}_{k-1}^+$$

wobei $C_{k-1}^+$ den vorherigen Kapazitätsschätzwert, $\delta C_{k-1}^+$ den vorherigen Schätzfehlerwert, k und k-1 aufeinanderfolgende Schätzzeitpunkte bezeichnen.

Die Zustandskovarianzmatrix P wird vorzugsweise in jedem Schätzschritt verändert gemäß

$$P = \begin{bmatrix} p_{11} & p_{12} \\ p_{21} & p_{22} \end{bmatrix}_k^- = \left( \begin{bmatrix} p_{11} & p_{12} \\ p_{21} & p_{22} \end{bmatrix}_{k-1}^+ + \begin{bmatrix} 0 & 0 \\ 0 & \Delta T \cdot \sigma_{n\delta CN}^2 \end{bmatrix}_k \right)$$

unabhängig davon, ob Messwerte vorliegen oder nicht.

Liegen Messwerte vor, so wird in dem jeweiligen Schätzschritt eine Kalman-Gain-Matrix vorzugsweise aktualisiert gemäß

$$\begin{bmatrix} k_{11} \\ k_{21} \end{bmatrix}_k = \left( \begin{bmatrix} p_{11} & p_{12} \\ p_{21} & p_{22} \end{bmatrix}_k^- \cdot \begin{bmatrix} \frac{\Delta S_{k,k-1}}{\eta} \\ \frac{\Delta S_{k,k-1}}{\eta} \end{bmatrix} \right)$$

$$\cdot \left( \begin{bmatrix} \frac{\Delta S_{k,k-1}}{\eta} & \frac{\Delta S_{k,k-1}}{\eta} \end{bmatrix} \cdot \begin{bmatrix} p_{11} & p_{12} \\ p_{21} & p_{22} \end{bmatrix}_k^- \cdot \begin{bmatrix} \frac{\Delta S_{k,k-1}}{\eta} \\ \frac{\Delta S_{k,k-1}}{\eta} \end{bmatrix} + \begin{bmatrix} \sigma_y^2 \end{bmatrix}_k \right)^{-1}$$

wobei $\Delta S_{k,k-1}$ eine Ladezustandsänderungsangabe und $\sigma_y^2$ eine Messtoleranzangabe bezeichnen.

Liegen Messwerte vor, so wird in dem jeweiligen Schätzschritt die Zustandskovarianzmatrix vorzugsweise aktualisiert gemäß

$$P_k^+ = \left( \begin{bmatrix} 1 & 0 \\ 0 & 1 \end{bmatrix} - \begin{bmatrix} k_{11} \\ k_{21} \end{bmatrix}_k \cdot \begin{bmatrix} \frac{\Delta S_{k,k-1}}{\eta} & \frac{\Delta S_{k,k-1}}{\eta} \end{bmatrix} \right) \cdot \begin{bmatrix} p_{11} & p_{12} \\ p_{21} & p_{22} \end{bmatrix}_k^-$$

bevor sie zu der Berechnung des Kapazitätsschätzwerts und des Schätzfehlerwerts herangezogen wird.

Liegen Messwerte vor, so werden der Kapazitätsschätzwert und der Schätzfehlerwert vorzugsweise berechnet auf der Basis der aktualisierten Kalman-Gain-Matrix und der aktualisierten Zustandskovarianzmatrix gemäß

$$\begin{bmatrix} C \\ \delta C \end{bmatrix}_k^+ = \begin{bmatrix} C \\ \delta C \end{bmatrix}_k^- + \begin{bmatrix} k_{11} \\ k_{21} \end{bmatrix}_k \cdot \left( y_{k,k-1} - \begin{bmatrix} \frac{\Delta S_{k,k-1}}{\eta} & \frac{\Delta S_{k,k-1}}{\eta} \end{bmatrix} \cdot \begin{bmatrix} C \\ \delta C \end{bmatrix}_k^- \right)$$

Die Erfindung bezieht sich außerdem auf eine Schätzeinrichtung zum Schätzen der Kapazität eines Energiespeichers unter Bildung eines Kapazitätsschätzwerts. Erfindungsgemäß ist die Schätzeinrichtung dazu ausgebildet, ein Verfahren wie oben beschrieben auszuführen.

Bezüglich der Vorteile der erfindungsgemäßen Schätzeinrichtung und deren vorteilhafter Ausgestaltungen sei auf die obigen Ausführungen im Zusammenhang mit dem erfindungsgemäßen Verfahren und dessen vorteilhafter Ausgestaltungen verwiesen.

Vorteilhaft ist es, wenn die Schätzeinrichtung eine Recheneinrichtung und einen Speicher umfasst, in dem ein Softwareprogramm abgespeichert ist, das bei Ausführung durch die Recheneinrichtung die Recheneinrichtung zur Ausführung eines Verfahrens wie oben beschrieben veranlasst.

Die Erfindung bezieht sich außerdem auf ein Schienenfahrzeug, das eine Schätzeinrichtung wie oben beschrieben aufweist.

Die Schätzeinrichtung ist vorzugsweise dazu ausgestaltet, die Kapazität einer Traktionsbatterie des Schienenfahrzeugs zu schätzen.

Die Erfindung wird nachfolgend anhand von Ausführungsbeispielen näher erläutert, dabei zeigen beispielhaft:

Figur 1     ein Ausführungsbeispiel für ein erfindungsgemäßes Schienenfahrzeug,

Figur 2     den Betrieb einer Traktionsbatterie des Schienenfahrzeugs gemäß Figur 1 im zeitlichen Verlauf, wobei Stromflussphasen und stromlose Phasen sowie das Erzeugen von Ladungsmengenangaben und Ladezustandsangaben vereinfacht dargestellt sind,

Figur 3     ein Ausführungsbeispiel für ein Softwareprogrammmodul einer Schätzeinrichtung des Schienenfahrzeugs gemäß Figur 1 näher im Detail,

Fig.4-5     die Arbeitsweise des Softwareprogrammmoduls gemäß Figur 3 bei Nichtvorliegen aktueller Messwerte,

Figur 6     die Arbeitsweise des Softwareprogrammmoduls gemäß Figur 3 bei Vorliegen aktueller Messwerte, und

Figur 7    die Aufweitung der Unsicherheit des Kapazitätsfehlers über der Zeit, modelliert als stochastischer Wiener Prozess.

In den Figuren werden der Übersicht halber für identische oder vergleichbare Komponenten dieselben Bezugszeichen verwendet.

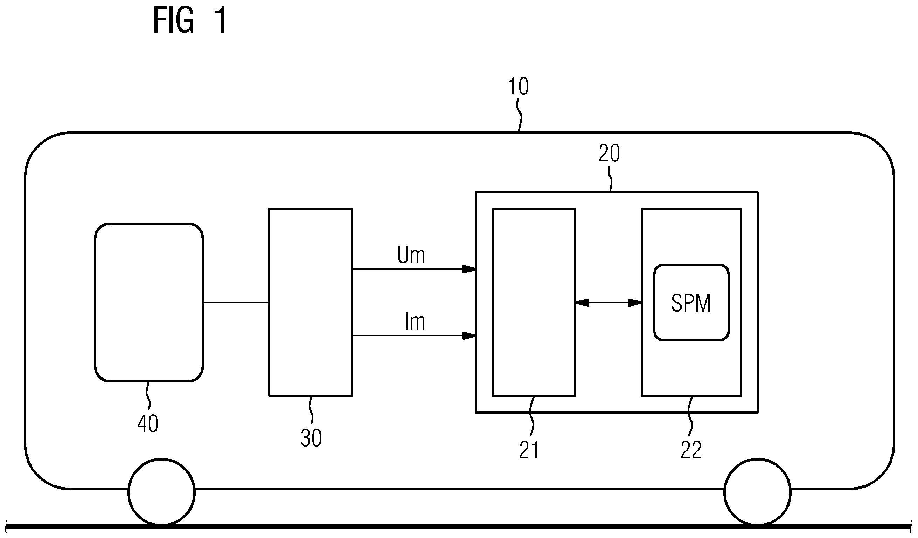

Die Figur 1 zeigt in einer schematischen Darstellung Bestandteile eines Ausführungsbeispiels für ein erfindungsgemäßes Schienenfahrzeug 10, das mit einem Ausführungsbeispiel für eine erfindungsgemäße Schätzeinrichtung 20 ausgestattet ist.

Die Schätzeinrichtung 20 ist über eine Messeinrichtung 30 mit einer Traktionsbatterie 40 des Schienenfahrzeugs 10 verbunden, die mit einem aus Gründen der Übersicht in der Figur 1 nicht gezeigten Antrieb des Schienenfahrzeugs 10 in Verbindung steht und diesen während des Antriebsbetriebs mit Traktionsstrom versorgen kann.

Die Funktion der Messeinrichtung 30 besteht darin, die an der Traktionsbatterie 40 anliegende Spannung unter Bildung von Spannungsmesswerten Um und den in bzw. aus der Traktionsbatterie 40 fließenden Strom unter Bildung von Strommesswerten Im zu messen. Die Messeinrichtung 30 überträgt ihre Strommesswerte Im und ihre Spannungsmesswerte Um an die Schätzeinrichtung 20.

Die Schätzeinrichtung 20 dient zum Schätzen der aktuellen Kapazität der Traktionsbatterie 40 unter Bildung eines Kapazitätsschätzwerts C und zum Bestimmen eines den Schätzfehler beim Schätzen des Kapazitätsschätzwerts C angebenden Schätzfehlerwerts $\delta C$. Zu diesem Zwecke umfasst die Schätzeinrichtung 20 eine Recheneinrichtung 21 und einen Speicher 22. In dem Speicher 22 ist ein Softwareprogrammmodul SPM abgespeichert, das bei Ausführung durch die Recheneinrichtung 21 die Schätzung der Kapazität und die Bestimmung des Schätzfehlers ermöglicht.

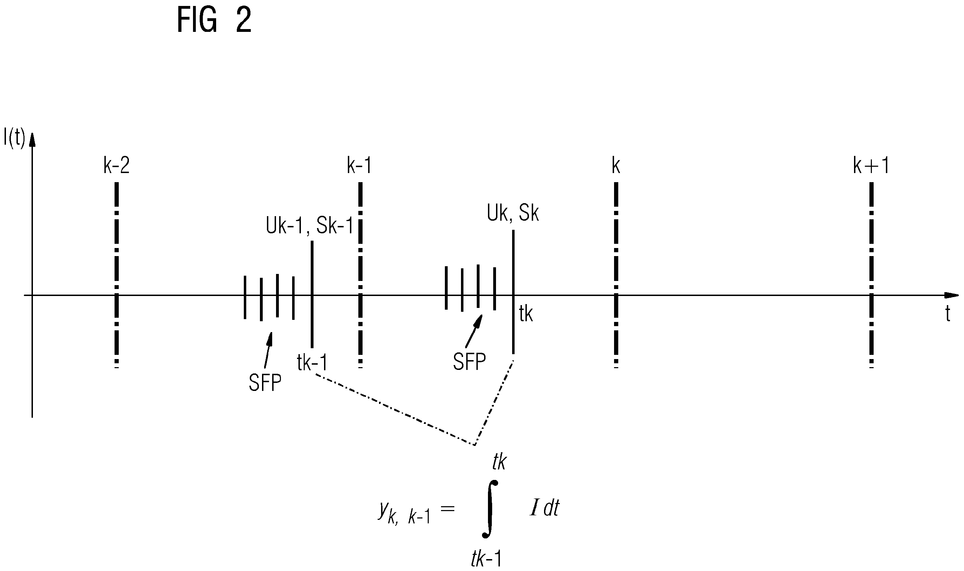

Die Figur 2 zeigt verschiedene Betriebszustände der Traktionsbatterie 40 in Form des Stromes I in bzw. aus der Traktionsbatterie 40 über der Zeit t. Es lassen sich Stromflussphasen erkennen, die mit dem Bezugszeichen SFP gekennzeichnet sind. Die Stromflussphasen SFP werden von stromlosen Phasen unterbrochen.

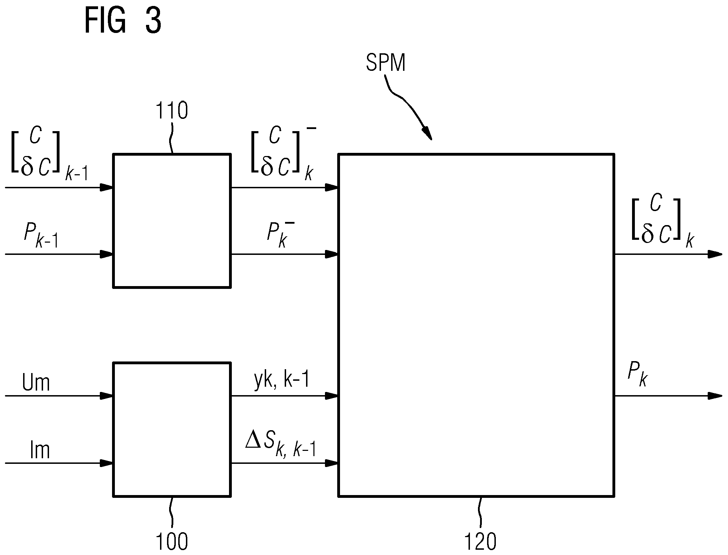

Die Figur 3 zeigt eine vorteilhafte Ausgestaltung des Softwareprogrammmoduls SPM der Schätzeinrichtung 20 gemäß Figur 1 in Form eines Blockschaltbildes. Das Softwareprogrammmodul SPM umfasst ein Auswertmodul 100, ein Propagationsmodul 110 und ein Updatemodul 120.

Die Funktion des Auswertmoduls 100 besteht darin, die Strommesswerte Im und die Spannungsmesswerte Um der Messeinrichtung 30 auszuwerten. Im Rahmen dieser Auswertung prüft sie unter anderem, ob stromlose Phasen vorliegen und ob im Falle erkannter stromloser Phasen diese eine vorgegebene Mindestzeitspanne anhalten. Ist dies der Fall, wird also eine stromlose Phase, die mindestens die Mindestzeitspanne erreicht hat, erkannt, so erfasst sie den zu Beginn der jeweiligen stromlosen Phase an der Traktionsbatterie 40 gemessenen Spanungsmesswert als Leerlaufspannungswert. In der Figur 2 sind zwei solcher Leerlaufspannungswerte mit den Bezugszeichen Uk und Uk-1 gekennzeichnet. Die Taktrate bzw. die Abtastrate beim Erfassen und Auswerten der Strommesswerte Im und der Spannungsmesswerte beträgt vorzugsweise mindestens 1 Hz.

Anhand der Leerlaufspannungswerte kann das Auswertmodul 100 den jeweiligen Ladezustand ermitteln, beispielsweise anhand einer für die Traktionsbatterie 40 typischen chemischen Spannungskennlinie bzw. Ladezustandskennlinie, unter Bildung von Ladezustandsangaben Sk:

$$Sk = f(U_k)$$

wobei f die Ladezustandskennlinie in Abhängigkeit von der jeweiligen Leerlaufspannung U beschreibt. Die Ladezustandsangabe nimmt vorzugsweise einen Wert zwischen Null (leere Traktionsbatterie) und 1 (vollgeladene Traktionsbatterie) an.

Durch Differenzbildung zwischen aufeinanderfolgenden Ladezustandsangaben kann eine Ladezustandsänderungsangabe $\Delta S_{k,k-1}$ ermittelt werden gemäß:

$$\Delta S_{k,k-1} = S_k - S_{k-1}$$

Darüber hinaus ermittelt das Auswertmodul 100 bei Vorliegen eines jeden neuen Leerlaufspannungswerts eine Ladungsmenge, die im Zeitraum zwischen der Erfassung des zeitlich letzten bzw. neuen Leerlaufspannungswerts (Zeitpunkt tk) und der Erfassung des zeitlich vorletzten Leerlaufspannungswerts (Zeitpunkt tk-1) in die Traktionsbatterie 40 hinein- oder aus dieser herausgeflossen ist, unter Bildung einer Ladungsmengenangabe $y_{k,k-1}$, beispielsweise gemäß

$$y_{k,k-1} = \int_{tk-1}^{tk} I\, dt$$

wobei I den Batteriestrom bezeichnet.

Die Funktion des Propagationsmoduls 110 und des Updatemoduls 120 besteht darin, die Schätzung der Kapazität der Traktionsbatterie 40 vorzunehmen, und zwar in Abhängigkeit davon, ob das Auswertmodul 100 eine aktuelle Ladezustandsänderungsangabe $\Delta S_{k,k-1}$ und eine aktuelle Ladungsmengenangabe $y_{k,k-1}$ zur Verfügung stellt oder nicht. Das Schätzen wird also davon abhängig gemacht, ob zum jeweiligen Schätzzeitpunkt k aktuelle Messwerte, die eine messwertgestützte Schätzung ermöglichen, vorliegen oder nicht: Bei Nichtvorliegen aktueller Messwerte wird die Schätzung allein auf der Basis des jeweils zuvor geschätzten Kapazitätsschätzwerts und des jeweils zuvor geschätzten Schätzfehlerwerts durchgeführt; bei Vorliegen aktueller Messwerte wird die Schätzung auf der Basis des jeweils zuvor geschätzten Kapazitätsschätzwerts, des jeweils zuvor geschätzten Schätzfehlerwerts und zusätzlich auf der Basis der aktuellen Messwerte, vorzugsweise der jeweils aktuellen Ladezustandsänderungsangabe $\Delta S_{k,k-1}$ und der jeweils aktuellen Ladungsmengenangabe $y_{k,k-1}$, durchgeführt.

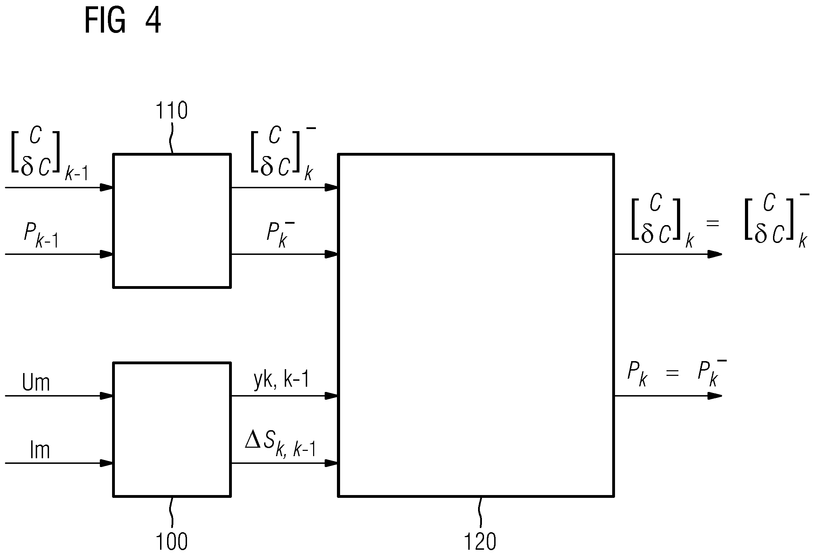

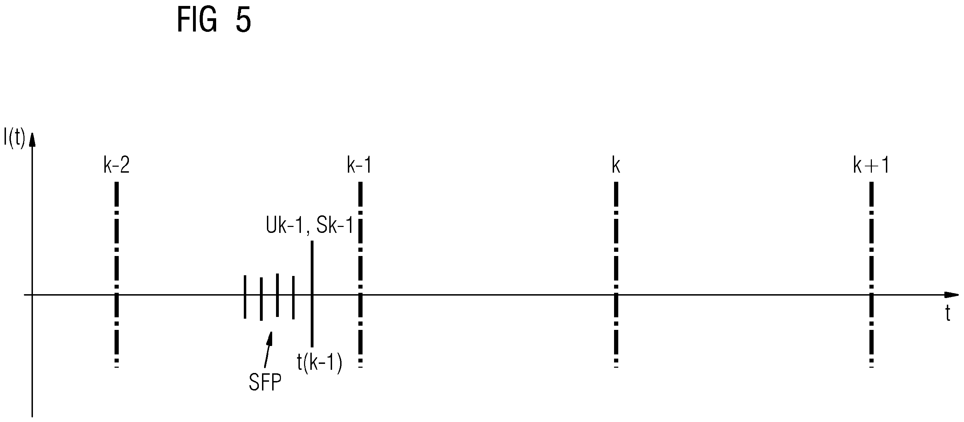

Die Figur 4 zeigt die Arbeitsweise des Propagationsmoduls 110 und des Updatemoduls 120 zum Schätzzeitpunkt k für das in Figur 5 gezeigt Szenario. Wie sich in der Figur 5 erkennen lässt, wurde in der Zeitspanne zwischen dem aktuellen Schätzzeitpunkt k und dem zeitlich davor liegenden Schätzzeitpunkt k-1 keine Stromflussphase beendet, sodass kein neuer Leerlaufspannungswert erzeugt wurde. Demgemäß kann das Auswertmodul 100 ausgangsseitig zum Schätzzeitpunkt k weder eine Ladungsmengenangabe $y_{k,k-1}$ noch eine dazu passende Ladezustandsänderungsangabe $\Delta S_{k,k-1}$ bilden.

Die Schätzung der Kapazität der Traktionsbatterie 40 erfolgt somit zum Schätzzeitpunkt k mangels aktueller Messwerte allein auf der Basis des jeweils zuvor geschätzten Kapazitätsschätzwerts Ck-1 und des jeweils zuvor geschätzten Schätzfehlerwerts δCk-1. Die Schätzung wird allein von dem Propagationsmodul 110 durchgeführt, das Updatemodul 120 bleibt inaktiv.

Das Propagationsmodul 110 arbeitet vorzugsweise auf der Basis einer Kalman-Filterung. In der nachfolgenden Tabelle sind in der linken Spalte die typischen Kalman-Filtergleichungen und in der rechten Spalte beispielhaft eine konkrete Ausgestaltung der Kalman-Filtergleichungen zur Bestimmung des Kapazitätsschätzwertes C und des Schätzfehlerwerts δC aufgeführt:

| | |
|---|---|
| $z_k^- = (I + \Delta T \cdot A_k) \cdot z_{k-1}^+$ | $\begin{bmatrix} C \\ \delta C \end{bmatrix}_k^- = \left( \begin{bmatrix} 1 & 0 \\ 0 & 1 \end{bmatrix} + \Delta T \cdot \begin{bmatrix} 0 & 0 \\ 0 & 0 \end{bmatrix} \right) \cdot \begin{bmatrix} C \\ \delta C \end{bmatrix}_{k-1}^+$ |
| $P_k^- = \phi_k \cdot P_{k-1}^+ \cdot \phi_k^T + Q_k$ | $\begin{bmatrix} p_{11} & p_{12} \\ p_{21} & p_{22} \end{bmatrix}_k^- = \left( \begin{bmatrix} p_{11} & p_{12} \\ p_{21} & p_{22} \end{bmatrix}_{k-1}^+ + \begin{bmatrix} 0 & 0 \\ 0 & \Delta T \cdot \sigma_{n\delta CN}^2 \end{bmatrix}_k \right)$ |
| $\phi_k$ | $\left( \begin{bmatrix} 1 & 0 \\ 0 & 1 \end{bmatrix} + \Delta T \cdot \begin{bmatrix} 0 & 0 \\ 0 & 0 \end{bmatrix} \right)_k$ |

Wie sich den obigen Gleichungen entnehmen lässt, berechnet das Propagationsmodul 110 einen Modellkapazitätsschätzwert $C_k^-$, einen Modellkapazitätsschätzfehlerwert $\delta C_k^-$ und eine Zustandskovarianzmatrix $P_k^-$, die zu dem Updatemodul 120 übermittelt werden.

Gemäß den obigen Gleichungen werden der jeweils zuvor geschätzte Kapazitätsschätzwert $C_{k-1}$ als aktueller Modellkapazitätsschätzwert $C_k^-$ und der jeweils zuvor geschätzte Schätzfehlerwert $\delta C_{k-1}$ als aktueller Modellschätzfehlerwert $\delta C_k^-$ ausgegeben.

Außerdem wird ein die Varianz des Schätzfehlerwerts bzw. des Modellschätzfehlerwerts $\delta C_k^-$ angebender Varianzwert p22 gemäß einer vorgegebenen Erhöhungsvorschrift, hier durch Addition des Summanden $+\Delta T \cdot \sigma_{n\delta CN}^2$

, erhöht, und es wird der erhöhte Varianzwert in der vorherigen Zustandskovarianzmatrix $P_{k-1}$ anstelle des vorherigen Varianzwerts p22 abgespeichert, wodurch eine neue Zustandskovarianzmatrix $P_k^-$ gebildet wird. $\sigma_{n\delta CN}^2$ bezeichnet die Varianz des Stimulationsrauschens und wird vorzugsweise derart berechnet, dass sich für den Kapazitätsfehler eine Erhöhung der Unsicherheit bzw. eine Erhöhung seiner Varianz um $a$ % nach einem Jahr ergibt. Nachfolgend wird hier beispielhaft zugrunde gelegt, dass der Kalman-Filter-Algorithmus einmal pro Stunde durchgeführt wird:

$$\sigma_{\delta CN}^2 = \frac{a}{100} \cdot C_N = \sigma_{n\delta CN}^2 \cdot h_{year} \rightarrow \sigma_{n\delta CN}^2 = \frac{a \cdot C_N}{100 \cdot h_{year}}$$

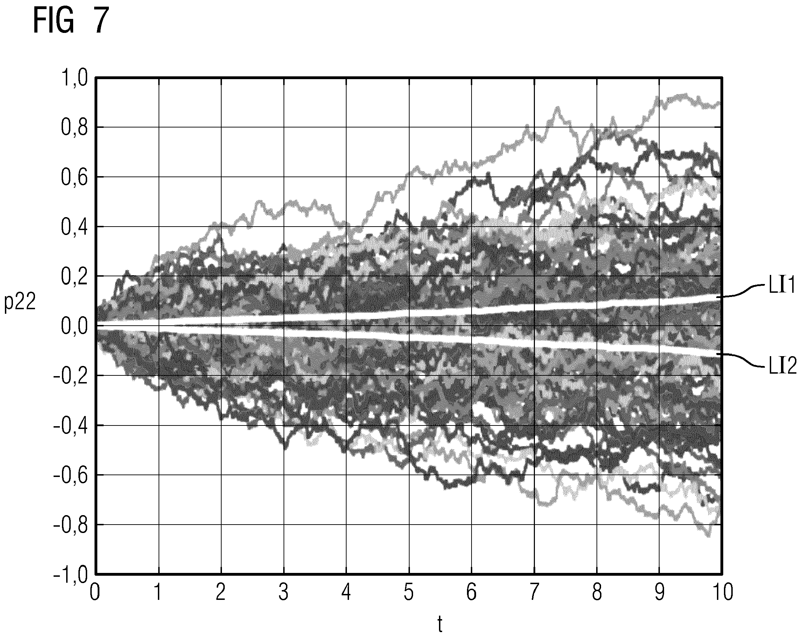

Die Grafik in Figur 7 zeigt die beispielhafte Aufweitung der Unsicherheit des Kapazitätsfehlers, also den Varianzwert p22, über der Zeit t für einen Zeitraum von 10 Jahren. Dargestellt sind 100 Realisierungen eines derartigen stochastischen Wiener Prozesses. Die mittlere Abweichung ist mit durchgezogenen weißen Linien LI1 und LI2 dargestellt und beträgt nach 10 Jahren ca. 10 %. Für $a$ wurde hierbei ein Wert von 1 % angenommen.

Da - wie bereits erwähnt - bei Nichtvorliegen aktueller Messwerte das Updatemodul 120 inaktiv ist, wird der aktuelle Modellkapazitätsschätzwert $C_k^-$ , also der vorherige Kapazitätsschätzwert $C_{k-1}$, als aktueller Kapazitätsschätzwert C von der Schätzeinrichtung 20 ausgegeben. Auch der Schätzfehlerwert $\delta C$ bleibt unverändert. Die Schätzeinrichtung 20 gibt also bei Nichtvorliegen aktueller Messwerte folgende Ergebnisse aus:

$$\begin{bmatrix} C \\ \delta C \end{bmatrix} = \begin{bmatrix} C \\ \delta C \end{bmatrix}_k^-$$

Geändert wird in jedem Propagationsschritt lediglich die Zustandskovarianzmatrix, wobei die geänderte Zustandskovarianzmatrix $P_k^-$ als Zustandskovarianzmatrix $P_k$ im nächsten Schätzschritt k+1 berücksichtigt wird.

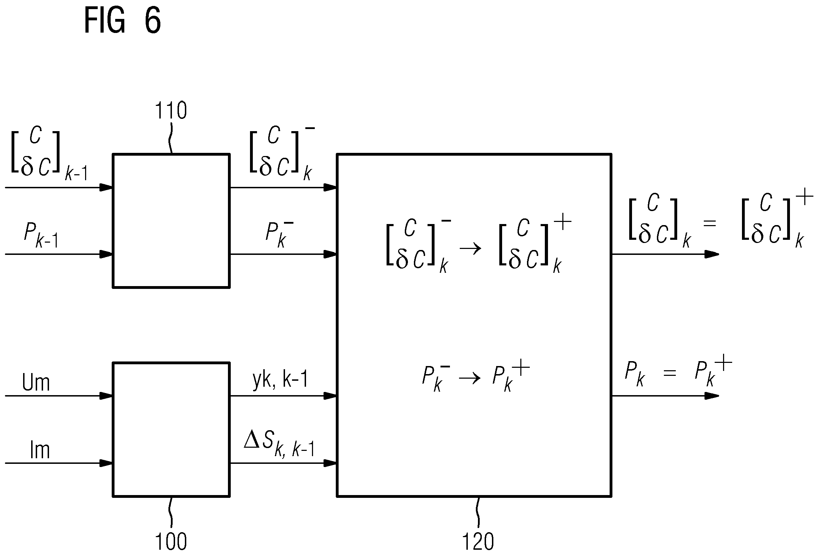

Die Figur 6 zeigt die Arbeitsweise des Propagationsmoduls 110 und des Updatemoduls 120 zum Schätzzeitpunkt k für das in Figur 2 gezeigt Szenario, bei dem - anders als in Figur 5 - in der Zeitspanne zwischen dem Schätzzeitpunkt k und dem zeitlich davor liegenden Schätzzeitpunkt k-1 eine Stromflussphase SFP beendet wurde, sodass das Auswertmodul 100 demgemäß einen neuen Leerlaufspannungswert Uk und eine neue Ladezustandsangabe Sk erzeugen kann. Mit der Ladezustandsangabe Sk wird eine neue Ladezustandsänderungsangabe $\Delta S_{k,k-1} = S_k - S_{k-1}$ gebildet.

Darüber hinaus erfasst das Auswertmodul 100 die Ladungsmenge, die zwischen der Bildung des Leerlaufspannungswertes Uk und der Bildung des vorherigen Leerlaufspannungswertes Uk-1 in die Traktionsbatterie 40 hinein- bzw. aus dieser herausgeflossen ist, unter Bildung der Ladungsmengenangabe $y_{k,k-1}$.

Die Ladungsmengenangabe $y_{k,k-1}$ und die Ladezustandsänderungsangabe $\Delta S_{k,k-1} = S_k - S_{k-1}$ werden zum Updatemodul 120 übertragen.

Durch die Übermittlung der Ladungsmengenangabe $y_{k,k-1}$ und der Ladezustandsänderungsangabe $\Delta S_{k,k-1}$ wird das Updatemodul 120 aktiviert, das nun den von dem Propagationsmodul 110 gelieferten Modellkapazitätsschätzwert und den Modellschätzfehlerwert $\begin{bmatrix} C \\ \delta C \end{bmatrix}_k^-$ auf der Basis der aktuellen Messwerte aktualisiert, vorzugsweise wie folgt:

| | |
|---|---|
| $K_k = (P_k^- \cdot h_k^T)$ $\cdot (h_k \cdot P_k^- \cdot h_k^T + R_k)^{-1}$ | $\begin{bmatrix} k_{11} \\ k_{21} \end{bmatrix}_k = \left( \begin{bmatrix} p_{11} & p_{12} \\ p_{21} & p_{22} \end{bmatrix}_k^- \cdot \begin{bmatrix} \frac{\Delta S_{k,k-1}}{\eta} \\ \frac{\Delta S_{k,k-1}}{\eta} \end{bmatrix} \right)$ $\cdot \left( \begin{bmatrix} \frac{\Delta S_{k,k-1}}{\eta} & \frac{\Delta S_{k,k-1}}{\eta} \end{bmatrix} \cdot \begin{bmatrix} p_{11} & p_{12} \\ p_{21} & p_{22} \end{bmatrix}_k^- \right.$ $\left. \cdot \begin{bmatrix} \frac{\Delta S_{k,k-1}}{\eta} \\ \frac{\Delta S_{k,k-1}}{\eta} \end{bmatrix} + [\sigma_y^2]_k \right)^{-1}$ |
| $P_k^+ = (I - K_k \cdot h_k) \cdot P_k^-$ | $P_k^+ = \left( \begin{bmatrix} 1 & 0 \\ 0 & 1 \end{bmatrix} - \begin{bmatrix} k_{11} \\ k_{21} \end{bmatrix}_k \cdot \begin{bmatrix} \frac{\Delta S_{k,k-1}}{\eta} & \frac{\Delta S_{k,k-1}}{\eta} \end{bmatrix} \right)$ $\cdot \begin{bmatrix} p_{11} & p_{12} \\ p_{21} & p_{22} \end{bmatrix}_k^-$ |
| $z_k^+ = z_k^- + K_k \cdot (y_{k,k-1} - h_k \cdot z_k^-)$ | $\begin{bmatrix} C \\ \delta C \end{bmatrix}_k^+ = \begin{bmatrix} C \\ \delta C \end{bmatrix}_k^- + \begin{bmatrix} k_{11} \\ k_{21} \end{bmatrix}_k$ $\cdot \left( y_{k,k-1} - \begin{bmatrix} \frac{\Delta S_{k,k-1}}{\eta} & \frac{\Delta S_{k,k-1}}{\eta} \end{bmatrix} \right.$ $\left. \cdot \begin{bmatrix} C \\ \delta C \end{bmatrix}_k^- \right)$ |

Den obigen Gleichungen lässt sich entnehmen, dass das Updatemodul 120 bei der Aktualisierung nicht nur die Ladungsmengenangabe $y_{k,k-1}$ und die Ladezustandsänderungsangabe $\Delta S_{k,k-1}$ berücksichtigt, sondern auch die Fehlervarianz $\sigma_y^2$ der Strommessung und den die Varianz des Modellschätzfehlerwerts $\delta C_k^-$ angebenden Varianzwert p22, der in der Zustandskovarianzmatrix P enthalten ist und in jedem Propagationsschritt jeweils von dem vorgeschalteten Propagationsmodul 110 erhöht wird.

Im Rahmen des Updateverfahrens, das das Updatemodul 120 durchführt, wird aufgrund des Vorliegens aktueller Messwerte der die Varianz des Modellschätzfehlerwerts $\delta C_k^-$ angebende Varianzwert p22 in der Regel wieder reduziert.

Der Kapazitätsschätzwert C und der Schätzfehlerwert $\delta C$ werden nachfolgend wie folgt ermittelt:

$$\begin{bmatrix} C \\ \delta C \end{bmatrix} = \begin{bmatrix} C \\ \delta C \end{bmatrix}_k^+$$

Die geänderte Zustandskovarianzmatrix $P_k^+$ und die geänderte Kalman-Gain Matrix $K_k$ werden abgespeichert und für den nächsten Schätzschritt k+1 verwendet.

Die in den obigen Gleichungen verwendeten Formelzeichen bedeuten dabei Folgendes:

| | |
|---|---|
| $C$ [Ah] | Kapazitätsschätzwert |
| $S$ (0,1) | Ladezustand (State of Charge, SoC) |

(fortgesetzt)

| | | |
|---|---|---|
| K | Kalman-Gain-Matrix |
| k11, k21 | Elemente der Kalman-Gain-Matrix |
| $I\,[A]$ | Strom |
| $t\,[s]$ | Zeit |
| $y\,[Ah]$ | Integrierte Ladung (Coulomb-Count) |
| $\delta C\,[Ah]$ | Schätzfehlerwert |
| $\Delta T$ | Abtastzeit des Kalmanfilters (z.B. $\Delta T$ = 1h) bzw. zeitlicher Abstand zwischen den Schätzschritten des Kalman-Filters |
| $h_{year}$ | Stunden pro Jahr |
| $n_{\delta CN}$ | Stimulationsrauschen für Kapazitätsfehler |
| $\eta$ | Anpassungsfaktor |
| U | Batterieklemmenspannung im stromlosen Zustand (Open Circuit Voltage) |
| $\sigma_y^2$ | Fehlervarianz der Strommessung (Coulomb-Count) |
| $\sigma_{n\delta CN}^2$ | Varianz des Stimulationsrauschens |
| P | Zustandskovarianzmatrix |
| p11-p22 | Varianzwerte der Zustandskovarianzmatrix |

Als Startwerte für den Beginn des in den Figuren gezeigten Schätzalgorithmus können beispielsweise folgende Werte gewählt werden:

$$\texttt{p11 = p12 = p21 = p22 = 0}$$

$\delta C$ = 0 und

$$\texttt{C = CN,}$$

wobei CN die Nennkapazität des neuwertigen Energiespeichers bzw. des Energiespeichers im Originalzustand bezeichnet. $\sigma_y^2$ ist aus dem Datenblatt der eingesetzten Messsensoren entnehmbar.

Das oben im Zusammenhang mit den Figuren beispielhaft beschriebene Schätzverfahren kann in vorteilhafter Weise folgende Eigenschaften aufweisen:

Mittels eines Kalman-Filters kann aus der Abweichung zwischen einer durch Integration berechneten Ladezustandsänderung und dem aus der Zellspannungskennlinie tatsächlich ermittelten Ladezustand auf die Änderung der Kapazität geschlossen werden.

Die Änderung der Kapazität kann über die Lebensdauer als ein Wiener Prozess modelliert werden. Dieses "Vorwissen" kann im Kalman-Filter berücksichtigt werden, wodurch die Schätzgenauigkeit bezüglich der Kapazitätsänderung verbessert wird.

Es kann eine Kalman-Filter-Architektur eingesetzt werden, welche direkt eine integrierte Strommessung als Beobachtung verarbeitet und damit wesentlich einfacher hinsichtlich der Implementierung als andere Verfahren ist. Es ergibt sich dadurch eine relativ einfache Kalman-Filter-Beobachtungsgleichung. Dies wiederum erleichtert die Berechnung des Kalman-Gains (Kalman-Gewinns K) aufgrund kleinerer Matrizen, welche gerade bei Echtzeitimplementierungen weniger Rechenschritte für deren Invertierung erfordern.

Durch eine Trennung der Messwertbildung und Stromintegration im Block 100 gemäß Fig. 6 und des Updatemoduls 120 gemäß Fig. 6 kann eine merkliche Reduktion der notwendigen Rechenoperationen erreicht werden. Die Stromintegration im Messwertblock kann mit hoher Frequenz erfolgen und damit kleinste Stromschwankungen erfassen. Der rechenintensive Updateblock 120 kann hingegen mit niedriger Frequenz realisiert werden. Im obigen Beispiel nur einmal pro Stunde.

Es werden vorzugsweise immer nur dann Messwerte im Kalman-Filter ausgewertet, wenn eine genaue Bestimmung des Ladezustandes aus der Zellspannungskennlinie möglich ist. Ein Kriterium hierfür kann eine längere stromlose Phase sein. In der Zwischenzeit werden vorzugsweise nur die Modellgleichungen des Kalman-Filters gerechnet (vorzugsweise im Propagationsmodul 110), ohne dabei Messergebnisse zu verwenden. Dadurch können Fehler aufgrund fehlerhafter Spannungsmessungen ausgeschlossen und die Genauigkeit der Kapazitätsschätzung erhöht werden.

Es kann eine optimierte Architektur für Echtzeitumgebungen erreicht werden. Die Kalman-Filter-Gleichungen werden vorzugsweise mit einer sehr niedrigen Abtastrate berechnet, z. B. nur 1-mal pro Stunde. Die Erfassung der Strommesswerte erfolgt vorzugsweise mit einer sehr hohen Abtastrate vorzugsweise im Sub-Sekundenbereich, um eine hohe Genauigkeit bei der Stromintegration zu gewährleisten.

**Patentansprüche**

1. Verfahren zum Schätzen der Kapazität eines Energiespeichers unter Bildung eines Kapazitätsschätzwerts (C), wobei im Rahmen des Verfahrens der Kapazitätsschätzwert (C) und ein den Schätzfehler des Kapazitätsschätzwerts angebender Schätzfehlerwert ($\delta$C) bestimmt werden, **dadurch gekennzeichnet, dass** das Schätzen davon abhängig ist, ob zum jeweiligen Schätzzeitpunkt aktuelle Messwerte (Uk, Uk-1, yk,k-1), die eine messwertgestützte Schätzung ermöglichen, vorliegen oder nicht, wobei

   - bei Nichtvorliegen aktueller Messwerte (Uk, Uk-1, yk,k-1) die Schätzung unter Heranziehung des jeweils zuvor geschätzten Kapazitätsschätzwerts und des jeweils zuvor geschätzten Schätzfehlerwerts durchgeführt wird und ein die Varianz des Schätzfehlerwerts ($\delta$C) beschreibender Varianzwert (p22) aktualisiert wird, und
   - bei Vorliegen aktueller Messwerte (Uk, Uk-1, yk,k-1) die Schätzung unter Heranziehung des jeweils zuvor geschätzten Kapazitätsschätzwerts, des jeweils zuvor geschätzten Schätzfehlerwerts, der aktuellen Messwerte und des Varianzwerts (p22) durchgeführt wird.

2. Verfahren nach Anspruch 1,
   **dadurch gekennzeichnet, dass**

   - jeweils bei Beginn einer stromlosen Phase geprüft wird, ob diese eine vorgegebene Mindestzeitspanne anhält, und gegebenenfalls eine an dem Energiespeicher anliegende Spannung unter Bildung eines Leerlaufspannungswertes (Uk, Uk-1) gemessen wird,
   - bei jedem Schätzvorgang jeweils geprüft wird, ob seit dem letzten Schätzvorgang zumindest ein neuer Leerlaufspannungswert (Uk) erfasst worden ist, und
   - bei Vorliegen zumindest eines neuen Leerlaufspannungswerts (Uk) eine Ladungsmenge, die im Zeitraum zwischen der Erfassung des zeitlich letzten neuen Leerlaufspannungswerts (Uk) und der Erfassung des zeitlich vorletzten Leerlaufspannungswerts (Uk-1) in den Energiespeicher hinein-oder aus diesem herausgeflossen ist, unter Bildung einer Ladungsmengenangabe (yk,k-1) ermittelt wird, und bei der Berechnung des Kapazitätsschätzwerts und des Schätzfehlerwerts als die genannten aktuellen Messwerte die zwei letztgenannten Leerlaufspannungswerte (Uk, Uk-1) und die Ladungsmengenangabe (yk,k-1) herangezogen werden.

3. Verfahren nach Anspruch 2,
   **dadurch gekennzeichnet, dass**
   die Erfassung der Ladungsmenge ein Abtasten des Stromes (I) mit einer Abtastrate umfasst, die zumindest hundertmal größer als die Wiederholrate der Schätzung ist.

4. Verfahren nach einem der voranstehenden Ansprüche,
   **dadurch gekennzeichnet, dass**
   bei Vorliegen aktueller Messwerte (Uk, Uk-1, yk,k-1)

   - die Schätzung zunächst ohne Berücksichtigung der aktuellen Messwerte durchgeführt wird unter Bildung eines Modellkapazitätsschätzwerts ( $C_k^-$ ) und eines Modellkapazitätsschätzfehlerwerts ( $\delta C_k^-$ ) und
   - anschließend der Kapazitätsschätzwert (C) und der Schätzfehlerwert ($\delta$C) unter Heranziehung des Modell-

kapazitätsschätzwerts, des Modellkapazitätsschätzfehlerwerts, der aktuellen Messwerte (Uk, Uk-1, yk,k-1) und des Varianzwerts (p22) berechnet werden.

**5.** Verfahren nach Anspruch 4,
**dadurch gekennzeichnet, dass**

die Berechnung des Modellkapazitätsschätzwerts ( $C_k^-$ ) und des Modellkapazitätsschätzfehlerwerts ( $\delta C_k^-$ ) bei Vorliegen der aktuellen Messwerte (Uk, Uk-1, yk,k-1) identisch ist mit der Berechnung des Kapazitätsschätzwerts und des Schätzfehlerwerts im Falle eines Nichtvorliegens aktueller Messwerte.

**6.** Verfahren nach einem der voranstehenden Ansprüche 4 bis 5, **dadurch gekennzeichnet, dass**

- der jeweils zuvor geschätzte Kapazitätsschätzwert ($C_{k-1}$) als Modellkapazitätsschätzwert ( $C_k^-$ ) und der jeweils zuvor geschätzte Schätzfehlerwert ($\delta C_{k-1}$) als Modellschätzfehlerwert ( $\delta C_k^-$ ) angesehen wird und
- der Varianzwert (p22) gemäß einer Erhöhungsvorschrift erhöht wird und der erhöhte Varianzwert in einer Zustandskovarianzmatrix (P) anstelle des vorherigen Varianzwerts abgespeichert wird, bevor die Zustandskovarianzmatrix (P) bei der Berechnung des Kapazitätsschätzwerts (C) und des Schätzfehlerwerts ($\delta C$) berücksichtigt wird.

**7.** Verfahren nach Anspruch 6,
**dadurch gekennzeichnet, dass**
die Erhöhungsvorschrift vorsieht, zur Bildung des erhöhten Varianzwerts (p22) den vorherigen Varianzwert um einen vorgegebenen Erhöhungswert ( $\Delta T \cdot \sigma_{n\delta CN}^2$ ) zu erhöhen, der proportional zu der Zeitspanne ($\Delta T$) zwischen der aktuellen Schätzung und der vorherigen Schätzung ist.

**8.** Verfahren nach einem der voranstehenden Ansprüche,
**dadurch gekennzeichnet, dass**
bei Nichtvorliegen aktueller Messwerte

- der vorherige Kapazitätsschätzwert und der vorherige Schätzfehlerwert unverändert gelassen werden und der vorherige Kapazitätsschätzwert als der aktuelle Kapazitätsschätzwert und der vorherige Schätzfehlerwert als der aktuelle Schätzfehlerwert ausgegeben werden und
- der Varianzwert im Rahmen der Aktualisierung durch Addition eines Erhöhungswerts ( $\Delta T \cdot \sigma_{n\delta CN}^2$ ) erhöht wird, der proportional zu der Zeitspanne ($\Delta T$) zwischen der aktuellen Schätzung und der vorherigen Schätzung ist.

**9.** Verfahren nach einem der voranstehenden Ansprüche,
**dadurch gekennzeichnet, dass**
die Schätzung in regelmäßigen zeitlichen Abständen wiederholt wird, unabhängig vom Vorliegen oder Nichtvorliegen aktueller Messwerte (Uk, Uk-1, yk,k-1).

**10.** Verfahren nach einem der voranstehenden Ansprüche,
**dadurch gekennzeichnet, dass**
bei Vorliegen aktueller Messwerte (Uk, Uk-1, yk,k-1) der Kapazitätsschätzwert und der Schätzfehlerwert berechnet werden unter Heranziehung

- des zuvor geschätzten Kapazitätsschätzwerts,
- des zuvor geschätzten Schätzfehlerwerts,
- der aktuellen Messwerte (Uk, Uk-1, yk,k-1),
- einer Messgenauigkeitsangabe ( $[\sigma_y^2]_k$ ), die die Messgenauigkeit der aktuellen Messwerte oder eines mit diesen berechneten Zwischenwerts angeben, und
- des Varianzwerts (p22).

**11.** Verfahren nach einem der voranstehenden Ansprüche,

**dadurch gekennzeichnet, dass**
die Schätzung mit einem Kalmanfilter durchgeführt wird.

12. Verfahren nach einem der voranstehenden Ansprüche,
   **dadurch gekennzeichnet, dass**
   der Schätzfehlerwert ($\delta$C) die Varianz des Kapazitätsschätzwerts (C) angibt.

13. Verfahren nach einem der voranstehenden Ansprüche 6 bis 12,
   **dadurch gekennzeichnet, dass**

   die Ermittlung des Modellkapazitätsschätzwerts $C_k^-$ und des Modellschätzfehlerwerts $\delta C_k^-$ erfolgt gemäß:

   $$\begin{bmatrix} C \\ \delta C \end{bmatrix}_k^- = \begin{bmatrix} C \\ \delta C \end{bmatrix}_{k-1}$$

   wobei $C_{k-1}$ den vorherigen Kapazitätsschätzwert, $\delta C_{k-1}$ den vorherigen Schätzfehlerwert, k und k-1 aufeinanderfolgende Schätzzeitpunkte bezeichnen und die Zustandskovarianzmatrix (P) verändert wird gemäß

   $$P = \begin{bmatrix} p_{11} & p_{12} \\ p_{21} & p_{22} \end{bmatrix}_k^- = \left( \begin{bmatrix} p_{11} & p_{12} \\ p_{21} & p_{22} \end{bmatrix}_{k-1}^+ + \begin{bmatrix} 0 & 0 \\ 0 & \Delta T \cdot \sigma_{n\delta CN}^2 \end{bmatrix}_k \right),$$

   bevor die Zustandskovarianzmatrix (P), der Modellkapazitätsschätzwert $C_k^-$ und der Modellschätzfehlerwert $\delta C_k^-$ zu der Berechnung des Kapazitätsschätzwerts (C) und des Schätzfehlerwerts ($\delta$C) herangezogen werden.

14. Schätzeinrichtung (20) zum Schätzen der Kapazität eines Energiespeichers unter Bildung eines Kapazitätsschätzwerts (C),
   **dadurch gekennzeichnet, dass**
   die Schätzeinrichtung (20) dazu ausgebildet ist, ein Verfahren nach einem der voranstehenden Ansprüche auszuführen.

15. Schienenfahrzeug (10),
   **dadurch gekennzeichnet, dass**
   das Schienenfahrzeug (10) eine Schätzeinrichtung (20) nach Anspruch 14 aufweist.


**Claims**

1. Method for estimating the capacity of an energy store to form a capacity estimate value (C), wherein, as part of the method, the capacity estimate value (C) and an estimate error value ($\delta$C) indicating the error value of the capacity estimate value are determined, **characterised in that** the estimation is dependent on whether or not prevailing measurement values (Uk, Uk-1, yk, k-1), which enable estimation supported by a measurement value, are present at the respective estimate time instant, wherein

   - in the absence of prevailing measurement values (Uk, Uk-1, yk, k-1), the estimation is carried out using the respective previously estimated capacity estimate value and the respective previously estimated estimate error value and a variance value (p22) which describes the variance of the estimate error value ($\delta$C) is updated, and
   - in the presence of prevailing measurement values (Uk, Uk-1, yk, k-1), the estimation is carried out using the respective previously estimated capacity estimate value, the respective previously estimated estimate error value, the prevailing measurement value and the variance value (p22).

2. Method according to claim 1,
   **characterised in that**

   - in each case, at the start of a zero-current phase, a check is made to ascertain whether the phase stops at a predefined minimum timespan, and if necessary, a voltage applied to the energy store is measured to form a no-load voltage value (Uk, Uk-1),

- in each case, a check is made at each estimation procedure to ascertain whether at least one new no-load voltage value (Uk) has been detected since the last estimation procedure, and

- in the presence of at least one new no-load voltage value (Uk), a charge quantity which has flown into or out of the energy store during the timespan between the detection of the most recent new no-load voltage value (Uk) and the detection of the second most recent no-load voltage value (Uk-1) is determined, to form a discharge charge quantity (yk, k-1), and during the calculation of the capacity estimate value and the estimate error value, the latter two no-load voltage values (Uk, Uk-1) and the discharge charge quantity (yk, k-1) are used as the stated prevailing measurement values.

3. Method according to claim 2,
   **characterised in that**
   the detection of the charge quantity comprises scanning the current (I) with a scan rate which is at least a hundred times greater than the repetition rate of the estimation.

4. Method according to one of the preceding claims,
   **characterised in that**,
   in the presence of prevailing measurement values (Uk, Uk-1, yk, k-1)

   - the estimation is firstly carried out without taking into account the prevailing measurement values to form a model capacity estimate value ( $C_k^-$ ) and a model capacity estimate error value ( $\delta C_k^-$ ) and
   - the capacity estimate value (C) and the estimate error value ($\delta$C) are then calculated using the model capacity estimate value, the model capacity estimate error value, the prevailing measurement values (Uk, Uk-1, yk, k-1) and the variance value (p22).

5. Method according to claim 4,
   **characterised in that**,
   in the presence of the prevailing measurement values (Uk, Uk-1, yk, k-1), the calculation of the model capacity estimate value ( $C_k^-$ ) and of the model capacity estimate error value ( $\delta C_k^-$ ) is identical to the calculation of the capacity estimate value and of the estimate error value in the absence of prevailing measurement values.

6. Method according to one of the preceding claims 4 to 5, **characterised in that**

   - the respective previously estimated capacity estimate value ($C_{k-1}$) is seen as the model capacity estimate value ( $C_k^-$ ) and the respective previously estimated estimate error value ($\delta C_{k-1}$) is seen as the model capacity estimate error value ( $\delta C_k^-$ ) and
   - the variance value (p22) is increased in accordance with an increase rule and the increased variance value is stored in a status covariance matrix (P) in place of the previous variance value before the status covariance matrix is taken into account for the calculation of the capacity estimate value (C) and the estimate error value ($\delta$C).

7. Method according to claim 6,
   **characterised in that**,
   to form the increased variance value (p22), the increase rule provides for the previous variance value to be increased by a predefined increase value ( $\Delta T \cdot \sigma_{n\delta CN}^2$ ), which is proportional to the timespan ($\Delta$T) between the prevailing estimation and the previous estimation.

8. Method according to one of the preceding claims, **characterised in that**
   in the absence of prevailing measurement values

   - the previous capacity estimate value and the previous estimate error value are left unchanged and the previous capacity estimate value is output as the prevailing capacity estimate value and the previous estimate error value as the prevailing estimate error value and

   - the variance value is increased by the addition of an increase value ( $\Delta T \cdot \sigma_{n\delta CN}^2$ ) as part of the update,

13

which increase value is proportional to the timespan (ΔT) between the prevailing estimation and the previous estimation.

9. Method according to one of the preceding claims,
   **characterised in that**
   the estimation is repeated at regular temporal intervals, independently of the presence or absence of prevailing measurement values (Uk, Uk-1, yk, k-1).

10. Method according to one of the preceding claims,
    **characterised in that**,
    in the presence of prevailing measurement values (Uk, Uk-1, yk, k-1), the capacity estimate value and the estimate error value are calculated using

    - the previously estimated capacity estimate value,
    - the previously estimated estimate error value,
    - the prevailing measurement value (Uk, Uk-1, yk, k-1),
    - a measurement accuracy indicator ( $[\sigma_y^2]_k$ ), which indicates the measurement accuracy of the prevailing measurement values or an intermediate value calculated from these, and
    - the variance value (p22).

11. Method according to one of the preceding claims,
    **characterised in that**
    the estimation is carried out using a Kalman filter.

12. Method according to one of the preceding claims,
    **characterised in that**
    the estimate error value (δC) indicates the variance of the capacity estimate value (C).

13. Method according to one of the preceding claims 6 to 12,
    **characterised in that**

    the determination of the model capacity estimate value $C_k^-$ and of the model estimate error value $\delta C_k^-$ takes place according to:

    $$\begin{bmatrix} C \\ \delta C \end{bmatrix}_k^- = \begin{bmatrix} C \\ \delta C \end{bmatrix}_{k-1}$$

    wherein $C_{k-1}$ denotes the previous capacity estimate value, $\delta C_{k-1}$ denotes the previous estimate error value, k and k-1 denote sequential estimate time instants and the status covariance matrix (P) is changed according to

    $$P = \begin{bmatrix} p_{11} & p_{12} \\ p_{21} & p_{22} \end{bmatrix}_k^- = \left( \begin{bmatrix} p_{11} & p_{12} \\ p_{21} & p_{22} \end{bmatrix}_{k-1}^+ + \begin{bmatrix} 0 & 0 \\ 0 & \Delta T \cdot \sigma_{n\delta CN}^2 \end{bmatrix}_k \right) ,$$

    before the status covariance matrix (P), the model capacity estimate value $C_k^-$ and the model estimate error value $\delta C_k^-$ are used to calculate the capacity estimate value (C) and the estimate error value (δC).

14. Estimation device (20) for estimating the capacity of an energy store to form a capacity estimate value (C), **characterised in that**
    the estimation device (20) is designed to carry out a method according to one of the preceding claims.

15. Rail vehicle (10),
    **characterised in that**
    the rail vehicle (10) has an estimation device (20) according to claim 14.

**Revendications**

1. Procédé d'estimation de la capacité d'un accumulateur d'énergie avec formation d'une valeur (C) d'estimation de la capacité,

   dans lequel

   dans le cadre du procédé, on détermine la valeur (C) d'estimation de la capacité et une valeur (5C) d'erreur de l'estimation indiquant l'erreur d'estimation de la valeur d'estimation de la capacité, **caractérisé en ce que** l'estimation dépend du point de savoir, si à l'instant respectif d'estimation, il y a ou non des valeurs (Uk, Uk-1, yk,k-1) de mesure en cours, qui rendent possible une estimation appuyée sur une valeur de mesure, dans lequel

   - s'il n'y a pas de valeur (Uk, Uk-1, yk,k-1) de mesure en cours, on effectue l'estimation en tirant parti de la valeur respective d'estimation de la capacité estimée auparavant et de la valeur respective d'erreur d'estimation estimée auparavant et on met à jour une valeur (p22) de variance, décrivant la variance de la valeur (5C) d'erreur de l'estimation, et
   - s'il y a des valeurs (Uk, Uk-1, yk,k-1) de mesure en cours, on effectue l'estimation en tirant parti de la valeur respective d'estimation de la capacité estimée auparavant, de la valeur respective de l'erreur d'estimation estimée auparavant, des valeurs de mesure en cours et de la valeur (p22) de variance.

2. Procédé suivant la revendication 1,
   **caractérisé en ce que**

   - l'on contrôle respectivement au début d'une phase sans courant, si celle-ci persiste à un laps de temps minimum donné à l'avance et, le cas échéant, on mesure une tension s'appliquant à l'accumulateur d'énergie avec formation d'une valeur (Uk, Uk-1) de tension à vide,
   - à chaque opération d'estimation, on contrôle respectivement, si depuis la dernière opération d'estimation, au moins une nouvelle valeur (Uk) de tension à vide a été détectée, et
   - s'il y a au moins une nouvelle valeur (Uk) de tension à vide, on détermine, avec formation d'une indication (yk,k-1) de quantité de charge, une quantité de charge, qui, dans le laps de temps entre la détection de la dernière dans le temps nouvelle valeur (Uk) de tension à vide et la détection de l'avant dernière dans le temps valeur (Uk-1) de tension à vide est entrée dans l'accumulateur d'énergie ou en est sortie et, dans le calcul de la valeur d'estimation de la capacité et de la valeur de l'erreur d'estimation, on tire parti, en tant que dites valeurs de mesure en cours, des deux valeurs (Uk, Uk-1) mentionnées en dernier de tension à vide et de l'indication (yk,k-1) de quantité de charge.

3. Procédé suivant la revendication 2,
   **caractérisé en ce que**
   la détection de la quantité de charge comprend un échantillonnage du courant (I) à un taux d'échantillonnage, qui est au moins cent fois plus grand que le taux de répétition de l'estimation.

4. Procédé suivant l'une des revendications précédentes, **caractérisé en ce que**
   s'il y a des valeurs (Uk, Uk-1, yk,k-1) de mesure en cours,

   - on effectue l'estimation d'abord sans tenir compte des valeurs de mesure en cours avec formation d'une valeur ( $C_k^-$ ) modèle de l'estimation de la capacité et une valeur ( $\delta C_k^-$ ) modèle de l'erreur de l'estimation de la capacité, et
   - on calcule ensuite la valeur (C) d'estimation de la capacité et de la valeur (5C) de l'erreur de l'estimation en tirant parti de la valeur modèle de l'estimation de la capacité, de la valeur modèle de l'erreur de l'estimation de la capacité, des valeurs (Uk, Uk-1, yk,k-1) de mesure en cours et de la valeur (p22) de la variance.

5. Procédé suivant la revendication 4,
   **caractérisé en ce que**

   le calcul de la valeur (C*) modèle de l'estimation de la capacité et de la valeur ( $\delta C_k^-$ ) modèle de l'erreur de l'estimation de la capacité est, s'il y a des valeurs (Uk, Uk-1, yk,k-1) de mesure en cours, le même que le calcul de la valeur de l'estimation de la capacité et de la valeur de l'erreur de l'estimation, s'il n'y a pas de valeurs de mesure en cours.

**6.** Procédé suivant l'une des revendications 4 à 5 précédentes, **caractérisé en ce que**

- on considère la valeur ($C_{k-1}$) respective d'estimation de la capacité estimée auparavant comme valeur ( $\bar{C_k}$ ) modèle d'estimation de la capacité et la valeur ($\delta C_{k-1}$) de l'erreur de l'estimation estimée auparavant comme valeur modèle ( $\bar{\delta C_k}$ ) de l'erreur de l'estimation, et
- on augmente la valeur (p22) de la variance suivant une prescription d'augmentation, et on met en mémoire la valeur augmentée de la variance dans une matrice (P) de covariance d'état au lieu de la valeur précédente de la variance, avant de prendre en compte la matrice (P) de covariance d'état, lors du calcul de la valeur (C) de l'estimation de la capacité et de la valeur (5C) de l'erreur de l'estimation.

**7.** Procédé suivant la revendication 6,
**caractérisé en ce que**
la prescription d'augmentation prévoit, pour la formation de la valeur (p22) augmentée de la variante, d'augmenter la valeur précédente de la variance d'une valeur d' augmentation ( $\Delta T \cdot \sigma^2_{n\delta CN}$ ) donnée à l'avance, qui est proportionnelle au laps ($\Delta T$) de temps entre l'estimation en cours et l'estimation précédente.

**8.** Procédé suivant l'une des revendications précédentes, **caractérisé en ce que**
s'il n'y a pas de valeur de mesure en cours,

- on laisse inchangée la valeur précédente d'estimation de la capacité et la valeur précédente de l'erreur de l'estimation et on donne la valeur précédente d'estimation de la capacité comme la valeur en cours d'estimation de la capacité et la valeur précédente de l'erreur de l'estimation comme la valeur en cours de l'erreur de l'estimation, et

- on augmente la valeur de la variance, dans le cadre de la mise à jour par addition d'une valeur ( $\Delta T \cdot \sigma^2_{n\delta CN}$ ) d'augmentation, qui est proportionnelle au laps ($\Delta T$) de temps entre l'estimation en cours et l'estimation précédente.

**9.** Procédé suivant l'une des revendications précédentes, **caractérisé en ce que**
l'on répète l'estimation à des distances régulières dans le temps indépendamment du point de savoir, s'il y a ou s'il n'y a pas des valeurs (Uk, Uk-1, yk,k-1) de mesure en cours.

**10.** Procédé suivant l'une des revendications précédentes, **caractérisé en ce que**
s'il y a des valeurs (Uk, Uk-1, yk,k-1) de mesure en cours, on calcule la valeur d'estimation de la capacité et la valeur de l'erreur d'estimation en tirant parti

- de la valeur d'estimation de la capacité estimée auparavant,
- de la valeur de l'erreur de l'estimation estimée auparavant,
- des valeurs (Uk, Uk-1, yk,k-1) de mesure en cours,
- d'une indication ( $\left[\sigma^2_y\right]_k$ ) de la précision de la mesure, qui indique la précision de mesure des valeurs de mesure en cours ou d'une valeur intermédiaire calculée avec celles-ci, et
- de la valeur (p22) de la variance.

**11.** Procédé suivant l'une des revendications précédentes, **caractérisé en ce que**
l'on effectue l'estimation avec un filtre de Kalman.

**12.** Procédé suivant l'une des revendications précédentes, **caractérisé en ce que**
la valeur (5C) de l'erreur de l'estimation indique la variance de la valeur (C) d'estimation de la capacité.

**13.** Procédé suivant l'une des revendications 6 à 12 précédentes, **caractérisé en ce que**

la détermination de la valeur $\bar{C_k}$ modèle de l'estimation de la capacité et de la valeur $\bar{\delta C_k}$ modèle de l'erreur de l'estimation s'effectue suivant :

$$\begin{bmatrix} C \\ \delta C \end{bmatrix}_k^{-} = \begin{bmatrix} C \\ \delta C \end{bmatrix}_{k-1}$$

dans laquelle $C_{k-1}$ désigne la valeur d'estimation de la capacité précédente, $\delta C_{k-1}$ la valeur de l'erreur de l'estimation précédente, k et k-1 des instants d'estimation successifs et on modifie la matrice (P) de la variance d'état suivant

$$P = \begin{bmatrix} p_{11} & p_{12} \\ p_{21} & p_{22} \end{bmatrix}_k^{-} = \left( \begin{bmatrix} p_{11} & p_{12} \\ p_{21} & p_{22} \end{bmatrix}_{k-1}^{+} + \begin{bmatrix} 0 & 0 \\ 0 & \Delta T \cdot \sigma_{n\delta CN}^2 \end{bmatrix}_k \right),$$

avant de tirer parti de la matrice (P) de la variance d'état, de la valeur $C_k^{-}$ modèle d'estimation de la capacité et de la valeur $\delta C_k^{-}$ modèle de l'erreur de l'estimation pour la calcul de la valeur (C) d'estimation de la capacité et de la valeur (5C) de l'erreur de l'estimation.

14. Dispositif (20) d'estimation pour l'estimation de la capacité d'un accumulateur d'énergie avec formation d'une valeur (C) d'estimation de la capacité,
**caractérisé en ce que**
le dispositif (20) d'estimation est constitué pour exécuter un procédé suivant l'une des revendications précédentes.

15. Véhicule (10) ferroviaire,
**caractérisé en ce que** le véhicule (10) ferroviaire a un dispositif (20) d'estimation suivant la revendication 14.

FIG 1

EP 4 220 207 B1

FIG 2

$$y_{k,\,k\text{-}1} = \int_{tk\text{-}1}^{tk} I\,dt$$

EP 4 220 207 B1

# FIG 3

EP 4 220 207 B1

FIG 4

EP 4 220 207 B1

$\begin{bmatrix} C \\ \delta C \end{bmatrix}_{k-1}$

$\begin{bmatrix} C \\ \delta C \end{bmatrix}_{k}^{-}$

$P_{k-1}$

$P_{k}^{-}$

110

$\begin{bmatrix} C \\ \delta C \end{bmatrix}_{k} = \begin{bmatrix} C \\ \delta C \end{bmatrix}_{k}^{-}$

Um

Im

yk, k-1

$\Delta S_{k, k-1}$

$P_{k} = P_{k}^{-}$

100

120

FIG 5

EP 4 220 207 B1

FIG 6

FIG 7

EP 4 220 207 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **RUI XIONG.** *A data-driven multi-scale extended Kalman filtering based parameter and state estimation approach of lithium-ion polymer battery in electric vehicles*